# EUROPEAN PATENT APPLICATION

(11) **EP 4 365 616 A1**
(43) Date of publication of application: **08.05.2024**
(21) Application number: 22205201.1
(22) Date of filing: 03.11.2022
(51) Int. Cl.: G01R 33/3815, G01R 33/385

(54) **COIL ASSEMBLY FOR A MAGNETIC RESONANCE EXAMINATION SYSTEM COMPRISING AN UNSHIELDED GRADIENT COIL**

(71) Applicant: Koninklijke Philips N.V., 5656 AG Eindhoven (NL)
(72) Inventor: OVERWEG, Johannes Adrianus, Eindhoven (NL)
(74) Representative: Philips Intellectual Property & Standards

(57) **Abstract**

The invention relates to the field of magnet coil assemblies for magnetic resonance examination systems with the objective to minimize a voltage induced in each of the windings of a superconducting magnet 2 surrounding a gradient system. This is achieved by providing a magnet coil assembly (1) with an unshielded gradient coil (3), wherein the unshielded gradient coil (3) has two separate compartments (4, 5), an imaging compartment (4) around an examination zone of the main magnet and at least an auxiliary compartment (5) that is offset adjacent from the imaging compartment (4) in a radial or axial direction of the main magnet (2), wherein the imaging compartment (4) and the auxiliary compartment (5) comprising coil windings (7, 8), wherein the coil windings (7, 8) are placed over the surface of the imaging compartment (4) and the auxiliary compartment (5) and are placed each at least in part along the boundary (10) between the compartments (4, 5).

## Description

### FIELD OF THE INVENTION

The invention relates to the field of magnet coil assemblies for magnetic resonance examination systems and, more particularly, to a magnet coil assembly with an unshielded gradient coil.

### BACKGROUND OF THE INVENTION

Unshielded gradient coils are attractive because they offer better gradient efficiency and at the same time more patient space inside a certain magnet bore. Unshielded z-gradients are problematic because these couple inductively with the magnet and potentially induce extremely large voltages.
It would be very advantageous if a magnet/gradient coil can be made such that the external fields of the gradient coil penetrate the winding of the superconducting magnet. If the gradient coil does not need an active shielding layer the diameter of the magnet's warm bore can be made just slightly larger than the outer diameter of the gradient coil. This can be used to either reduce the size of the magnet for a given patient bore size or to increase the patient bore diameter for a certain magnet inner diameter. In all cases, the efficiency of the gradient coil would be significantly increased compared to a standard actively shielded gradient coil.

A prerequisite of a system with an unshielded gradient coil closely coupled to the magnet is that all cryostat shells immediately outside the gradient coil must be transparent to changing magnetic fields. This implies a non-conducting magnet bore tube (a very thin metallic layer to make it vacuum tight would be allowed as long as its electrical time constant is much shorter than the typical switching time of the gradients). The radiation shield must be built from strips or wires, possibly combined with convective cooling loops or heat pipes, to remove the radiation heat without creating conductive patches that block the gradient field. Conducting loops in the inner regions of the cold mass must be avoided as well.

Exposing the magnet windings to the stray field of the gradients leads to a number of problems. Firstly, the A/C fields seen by the conductor will lead to eddy-current losses and these must be kept low enough that the cooling system does not get overloaded. This heating issue will, in principle, exist in a similar way for all three gradient axes. A second problem, which only pertains to the z-gradient axis is that the A/C field of the gradient will induce a large voltage in magnet coils with many windings. The transverse coils will not cause a net flux through the magnet windings and hence will not lead to significant induced voltages (provided the system is built symmetrically).

### SUMMARY OF THE INVENTION

It is an object of the invention to generate a uniform static magnetic field in an examination zone by an unshielded z-gradient coil.

According to the invention, this object is addressed by the subject matter of the independent claims. Preferred embodiments of the invention are described in the sub claims.

Therefore, according to the invention, a magnet coil assembly for a magnetic resonance examination system is foreseen the assembly comprising: a main magnet including superconducting windings to generate a uniform static main magnetic field in an examination zone and an unshielded gradient coil to generate magnetic gradient field waveforms, wherein the unshielded gradient coil has two separate compartments, an imaging compartment around an examination zone of the main magnet and at least an auxiliary compartment that is offset adjacent from the imaging compartment in a radial or axial direction of the main magnet, wherein the imaging compartment and the auxiliary compartment comprising coil windings, wherein the coil windings are placed over the surface of the imaging compartment and the auxiliary compartment and are placed each at least in part along the boundary between the compartments.

The voltage induced by a single-layer gradient coil in the sections of a superconducting magnet can be reduced to acceptable levels by several methods. Actively shielding in axial direction can effectively decouple the end sections of the magnet. Coupling with the central magnet sections can be avoided by winding these sections layer by layer, repeatedly crossing the magnet's midplane. Yet another approach, which results in the best gradient efficiency and at the same time inherently decouples the gradient coil from any magnet outside is to subdivide the gradient space into two compartments and to place windings around these such that a good imaging field and at the same time net flux compensation is achieved.

Thus, the transformer formed by the main magnet windings and the unshielded z-gradient coil is weakly coupled or even uncoupled. The invention avoids high inductive voltages to occur in the superconducting windings of the main magnet. The unshielded z-gradient coil does not a need surrounding shield layer. This enables a wider bore size of e.g., 80cm. It is noted that the saddle-coil arrangements for the transverse gradient coils inherently have low flux coupled with the main magnet's windings as long as they are anti-symmetric relative to the magnet. The key element in decoupling a single-layer gradient coil from a complete magnet is to subdivide the space inside the coil into two compartments and to place windings on the boundary between these two compartments.

In a technically advantageous embodiment of the magnet coil assembly the coil windings of the auxiliary compartment carry the same current as the coil windings of the imaging compartment.

In another technically advantageous embodiment of the magnet coil assembly wherein the coil windings of the auxiliary compartment and coil windings of the imaging compartment are connected in series. By means of a series connection of the windings, it can be achieved in a simple way that the same current flows in the windings.

In a technically advantageous embodiment of the magnet coil assembly the imaging compartment surrounds an examination space of the magnetic resonance examination system, wherein the auxiliary compartment is the remainder of the cylindrical coil volume below a patient table of the magnetic resonance examination system.

In another technically advantageous embodiment of the unshielded gradient coil is a longitudinal z-gradient coil or an asymmetrical up/down-gradient coil.

In an advantageous embodiment of the invention the boundary of the imaging compartment next to the auxiliary compartment is located in the range between 100 and 200 mm below the iso-center of the main magnet.

The present invention also provides a magnetic resonance examination system, the magnetic resonance examination system comprising a magnet coil assembly as described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 depicts an unshielded z-gradient coil with tightly fitted magnet coils with a map of its magnetic field,
Fig. 2 shows a diagram of the induced voltage per magnet turn as function of a turn axial position,
Fig. 3 schematically depicts a single layer z-gradient coil with axial shielding,
Fig. 4 shows a diagram of the induced voltage per turn of axially shielded gradient,
Fig. 5 shows a diagram of the z-gradient field at inner layer of windings,
Fig. 6 shows a design of a magnet with long central solenoid section,
Fig. 7 schematically depicts a cross-section of a two-compartment gradient coil according to an embodiment of the invention,
Fig. 8 shows in Fig 8 a) a field map of a two-compartment inductively decoupled z-gradient design, wherein in Figs. 8 b) to d) parts of the coil are shown separately according to an embodiment of the invention,
Fig. 9 shows a diagram of the induced voltage per magnet winding for 10 mT/m and 1 kHz according to an embodiment of the invention,
Fig. 10 shows a diagram of the magnitude of the z-gradient field at inner layer of magnet windings according to an embodiment of the invention,
Fig. 11 depicts a field map of an asymmetric Y-coil around upper gradient compartment,
Fig. 12 depicts in Fig. 12 a) a field map of an asymmetric up/down gradient with decoupling coil in lower compartment, wherein in Figs. 12 b) to d) parts of the coil are shown separately according to an embodiment of the present invention.

### DETAILED DESCRIPTION OF EMBODIMENTS

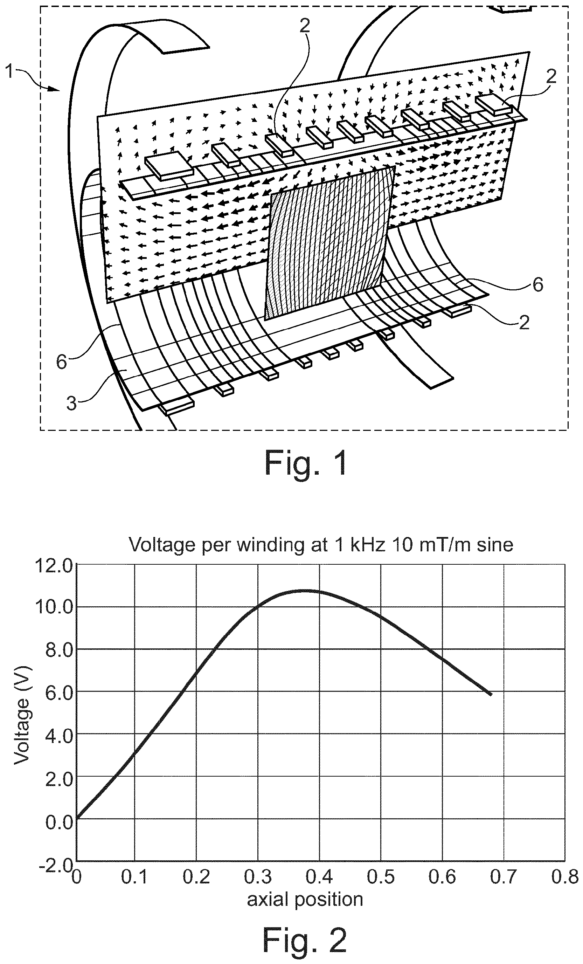

A typical example of an unshielded z-gradient coil 3 as shown in Fig. 1 will be analyzed below to get an estimate of the induced voltage problem that has to be solved. The example coil 3 has a diameter of 800 mm and it is assumed that this coil is combined with magnet windings 6 with an inner diameter of 840 mm. In the example, the gradient coil windings 6 are allowed to distribute over a coil length of 1500 mm and it is assumed that magnet windings can also appear over this entire length. Without any constraints on external field and requiring a good imaging field in an ellipsoid of 500 mm diameter and 450 mm length, the optimum winding distribution will look like what is shown in Fig. 1. Here and in all following examples of gradient coils the windings are shown as contours closed in themselves. It must be obvious to the person skilled in the art that these windings are all connected in series such that all windings carry the same current. The arrows indicate the field generated by the gradient coil 3. It is clear from the figure that this field will result in a significant net flux through each of the magnet windings. For this coil, at a gradient amplitude of 10 mT/m the flux through a single turn of the magnet was calculated as a function of the axial position of that turn. Multiplying this flux with 2π. f gives the peak voltage induced in that turn by a sinusoidal gradient of frequency f. Fig. 2 shows the result of this simulation. This simulation shows that already for magnet sections with 100 turns the induced voltage will be over 1kV. Magnet coils with hundreds of turns will be in danger of electrical breakdown. An additional problem will be that the frequency where magnet sections exhibit a self-resonance will be within the frequency range of the gradient system and if such a resonance is excited with very high amplitude it is very likely that this will lead to a quench.

There are at least three ways to reduce the coupling with a z-gradient coil without adding a shielding layer at larger diameter:
- Active shielding in axial direction with shield windings at the primary gradient diameter
- Voltage-cancellation inside the magnet windings by rigorous layer-by-layer winding.
- Compensating mutual inductance with complete magnet with a two-compartment gradient coil

These approaches will be explained in more detail in the next sections.

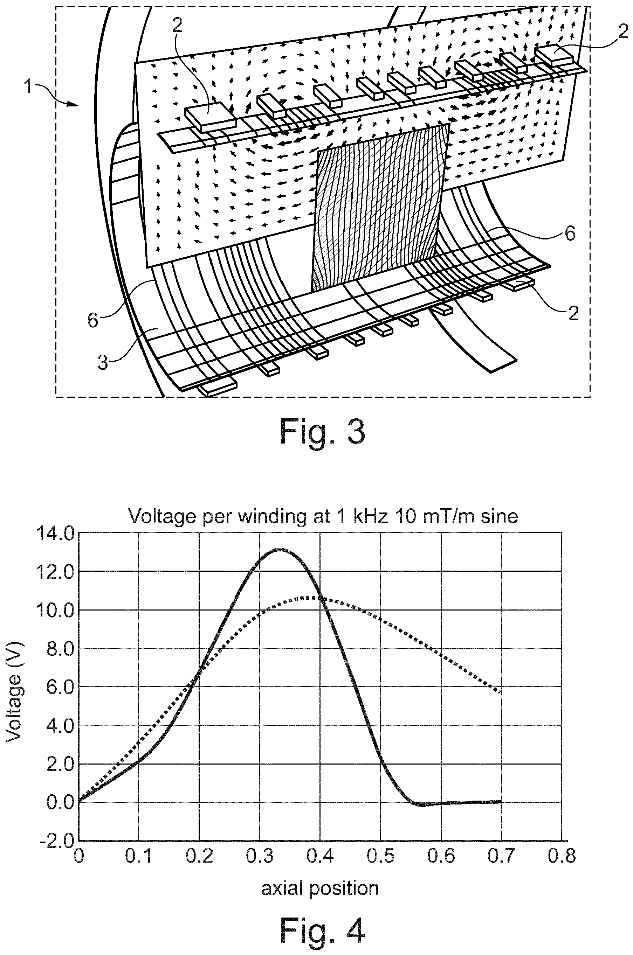

The coil 3 shown in Fig. 1 has a very low winding 6 density in the regions far from the midplane. This is advantageous if the objective is to get the most efficient gradient coil but, considering that the efficiency of the z-gradient is usually much better than that of the transverse gradients, it does not harm to deviate from this optimum geometry if this solves another problem. If the length of the gradient coil is constrained to 1 meter or less, it is still possible to generate a good imaging field and by doing so the coupling with the magnet windings in the outermost sections is reduced. As these are the sections with the largest number of turns, this reduction in gradient coil length is a good approach. But it is possible to go one step further: the end regions of the gradient coils 3 which are now empty can be used to place counter-running gradient windings 6, which actively shield the field from the central windings at the location of the magnet's end sections. Fig. 3 shows an example of such a single layer axially shielded coil 3, giving the same imaging field as the unconstrained coil of Fig. 1.

Constraining the coupling with the magnet's end coils increases the stored energy at 10 mT/m from 3.7 J to 6.7 J, but this is still lower than the stored energy of an actively shielded gradient coil of the same inner diameter. Fig. 4 shows the voltage induced in a single turn of a close-fitting magnet for this axially shielded z-gradient. The graph shows that all magnet windings at axial positions beyond 550 mm from the midplane are very effectively decoupled from the gradient field and no large, induced voltages are to be expected. It is also unlikely that, using this axial shielding method, special measures must be taken to avoid self-resonances in these end coils.

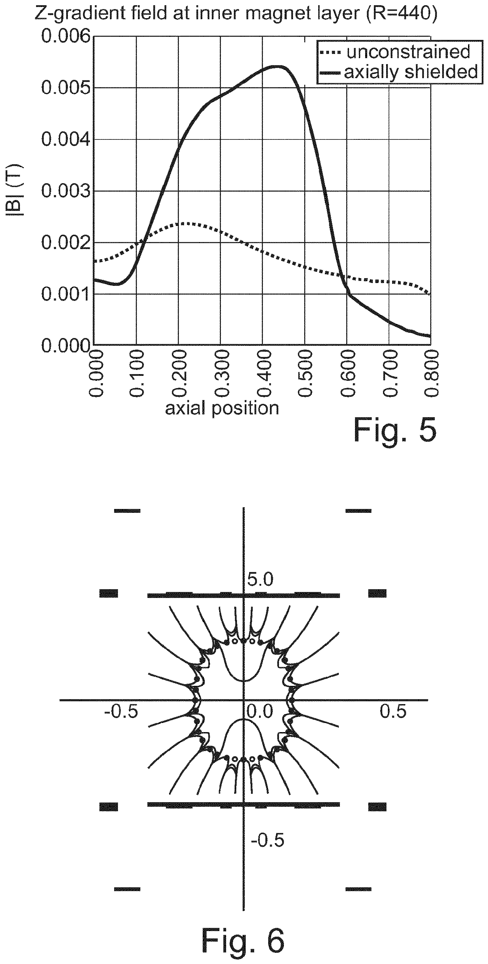

Because the return flux of the gradient coil 3 is forced out of the coil cylinder over a smaller area, the flux density there must increase. This leads to an increase in the amplitude of the gradient field reaching the central windings of the magnet, as shown in Fig. 5. At the end coils of the magnet 2 the amplitude of the gradient field is significantly reduced by the active shielding in axial direction. These magnet end coils have the largest amount of winding and the smallest temperature margin.

The next section describes how something can be improved in the central coil section.

Assuming that for windings in the region of peak coupling with the gradients the induced voltage will be of the order of 10V per turn and assuming that the potential to ground in the windings should be limited to 1-2 kV, it follows that something must be done if central sections of the coil have more than 100-200 turns. This will generally be the case in mid- or high-field MRI magnets. The solution to this problem is that after each 100-200 turns in the central region of the magnet one must cross the midplane and continue the coil circuit with the corresponding 100-200 turns of the other half of the magnet. By doing so repeatedly, the net voltage accumulated in such a layer spanning multiple coil sections is zero. Magnet designs with an odd number of coil sections, with one in the midplane are advantageous here, since these central sections are inductively decoupled automatically. An example design like this, for a field of 0.6 T is shown in Fig. 6.

The end coils of this magnet have a rather small aspect ratio, to keep all their windings in the low-field region of an axially shielded z-gradient coil. The central solenoid has a length of 800 mm. If it would be wound with a pitch of the order of 1 mm, the accumulated voltage over half a layer would still be far too large. This must be avoided by increasing the winding pitch. In the design of Fig. 6, the long solenoid has 4 layers of only 290 turns each (meaning that gradient voltage accumulation reverses after each 145 turns). This number of turns implies a winding pitch of 2.75 mm. This can best be manufactured by winding in a template and one such template is needed for each layer. This large separation between individual turns both axial and radial is useful to allow the gradient field to penetrate the magnet windings with acceptable eddy-current losses and to minimize the parasitic capacitance between the wires, leading to a high self-resonance frequency. The small field shaping sections on top of the solenoid have sufficiently small numbers of turns that they do not need special winding procedures.

By combining the methods described in the previous two sections, a system of a small-bore magnet with a closely fitting single-layer cylindrical z-gradient coil can be obtained without getting excessive voltages in the magnet. There is, however, another way to achieve the same objective and with this approach the magnet is inherently decoupled and can be wound as it suits best.

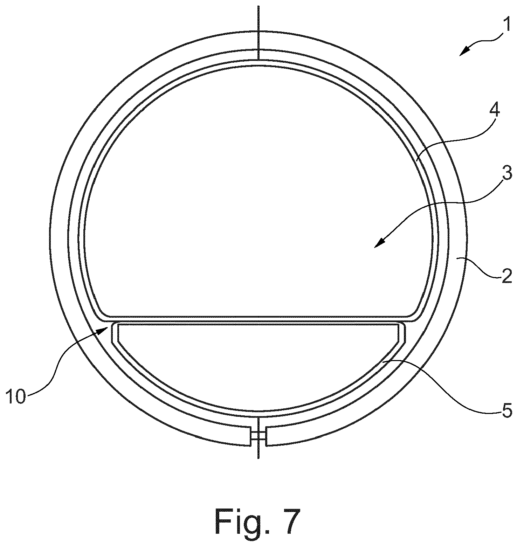

The key element in decoupling a single-layer gradient coil 3 from a complete magnet 2 is to subdivide the space inside the coil 3 into two compartments 4, 5 and to allow windings to be placed on the boundary 10 between these two as shown in Fig. 7. One compartment 4 is the space in an embodiment above the patient table (with some extra margin to allow for the thickness of the tabletop and the RF coil below the table) while the other compartment 5 is the entire bottom region below this separation. Fig. 7 shows the shape of the coil 3 in cross-section. In an embodiment shown in Fig. 7, the lower boundary of the imaging compartment is located at 180 mm below the iso-center.

In an embodiment of the invention the imaging compartment 4 surrounds an examination space of the magnetic resonance examination system, wherein the auxiliary compartment 5 is the remainder of the cylindrical coil volume below a patient table of the magnetic resonance examination system.

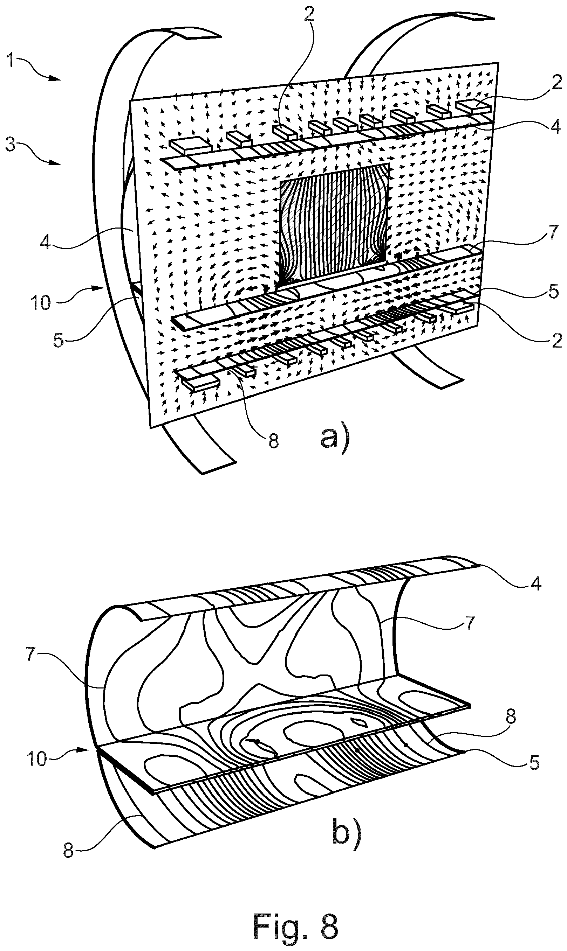

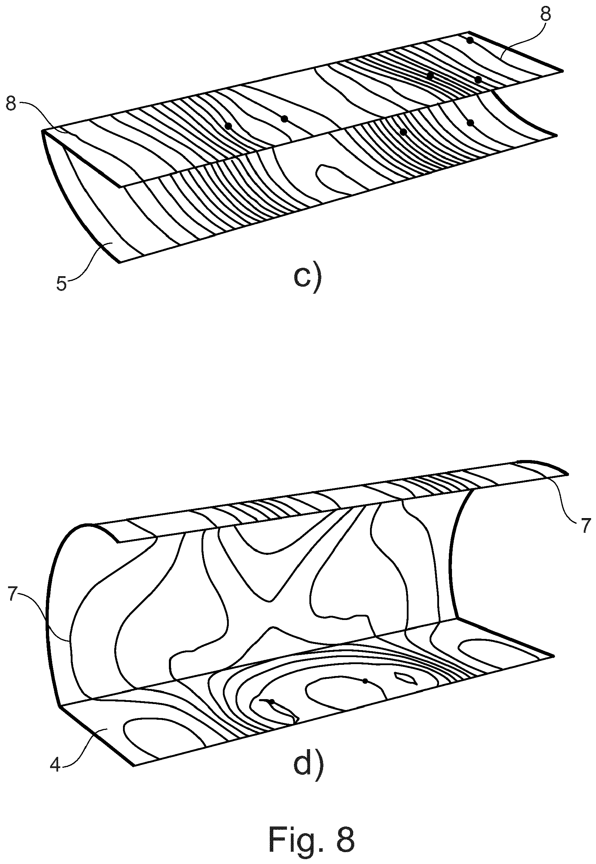

In the upper or imaging compartment the field must be of the same quality as for an equivalent cylindrical gradient. The purpose of the windings around the lower compartment is to balance the magnetic flux through the magnet windings for every axial position of such a winding. Fig. 8 a) shows a z-gradient coil 3 with an optimized winding pattern. To obtain an optimized winding pattern for the two sets of coils, the total rms magnetic flux coupled to a series of test windings placed on a cylinder with the same diameter as the superconducting magnet coils was added to the cost function of the numerical optimization. Other elements of this cost function are the deviation of the magnetic field in the imaging volume, the magnetic stored energy and dissipation, the local surface current density, the net magnetic force in the field of the main field magnet and possible other requirements added by the gradient coil designer.

In Fig. 8 a) a magnet coil assembly 1 is shown wherein the assembly comprises a main magnet 2 including superconducting windings 9 to generate a uniform static main magnetic field in an examination zone and an unshielded gradient coil 3 to generate magnetic gradient field waveforms. The unshielded gradient coil 3 has two separate compartments 4, 5, an imaging compartment 4 around an examination zone of the main magnet and at least an auxiliary compartment 5 that is offset adjacent from the imaging compartment 4 in a radial or axial direction of the main magnet 2. The imaging compartment 4 and the auxiliary compartment 5 comprising coil windings 7, 8, wherein the coil windings 7,8 are placed over the surface of the imaging compartment 4 and the auxiliary compartment 5 and are placed each at least in part along the boundary 10 between the compartments 4, 5. In an embodiment the coil windings 8 of the auxiliary compartment 5 carry the same current as the coil windings 7 of the imaging compartment 4. this can be achieved, for example, by connecting the coil windings 8 of the auxiliary compartment 5 and coil windings 7 of the imaging compartment 4 in series. However, the current in the coil windings 7, 8 can also be different.

In Figs. 8 b) to c) only parts of the coil for a better overview are shown. In Fig. 8 b) the imaging compartment 4 and auxiliary compartment 5 are shown as sectional drawing. In particular, the coil windings 7, 8 can be recognized on the surface of the compartments 4, 5. In Particular, the coil windings 7, 8 run along the boundary 10 between the compartments 4, 5. In Fig. 8 c) only the auxiliary compartment 5 with its coil windings 8 is shown as sectional drawing. In Fig. 8 d) only the imaging compartment 4 with its coil windings 7 is shown as sectional drawing.

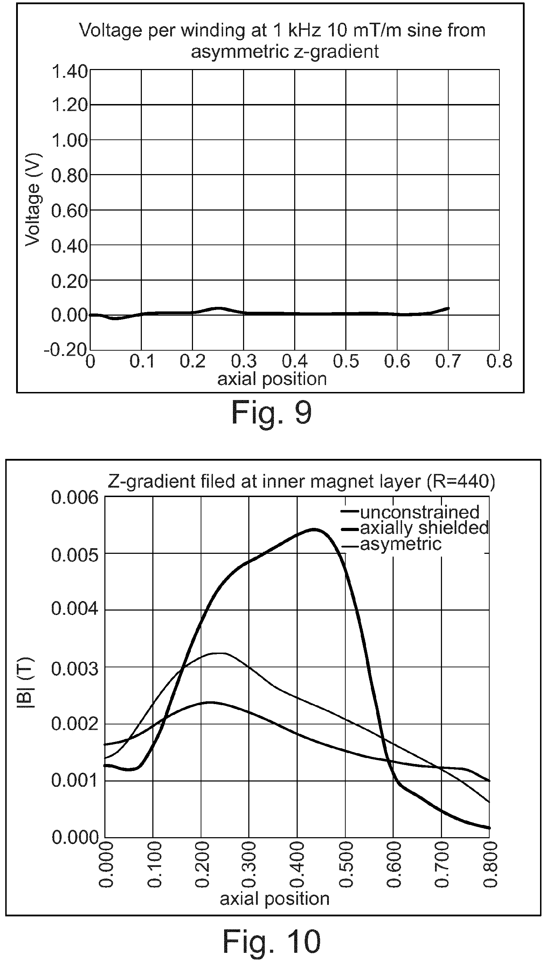

Fig. 9 shows that the compensating windings in the lower compartment balance the mutual inductance between the gradient coil and the magnet surprisingly well. Even with a tenfold expansion of the vertical scale compared to figure 4, there is hardly anything visible.

That there is no net flux through any magnet winding does not mean that this gradient coil does not produce any field at the location of the magnet windings. Fig. 10 shows the magnitude of this field in comparison with the unconstrained and axially compensated equivalent gradient coils.

The stored energy of the two-compartment coil of Fig. 8 at 10 mT/m is 5.8 J, so it is more efficient than the axially shielded coil described earlier on.

In principle, a two-compartment z-gradient can be combined with cylindrical transverse gradients, wrapping around the outer surface of the z-gradient. Alternatively, the presence of a lower boundary of the imaging compartment can be utilized to get a significant improvement in the efficiency of these transverse coils and at the same time reduce the field they create at the magnet windings. A cylindrical X or Y gradient of about 800 mm diameter, compatible with the z-coil of Fig. 8, has a stored energy at 10 mT/m of 6.8 Joule. An equivalent Y-coil following the contour of the upper compartment of the z-gradient coil has a stored energy of only 4.1 J, which means the amplifier needed to drive it can be 40% smaller. Here the Y-direction indicates the transverse direction parallel to the surface of the patient table, whereas the X direction is the transverse direction normal to the surface of the patient table.

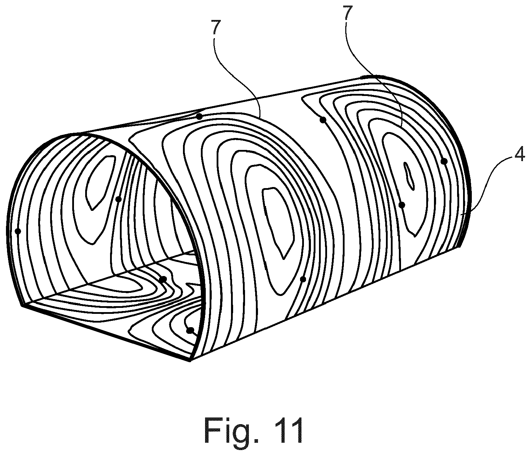

For symmetry reasons, the imaging compartment 4 of an unshielded gradient coil, shown in Fig. 11, does not couple inductively to any of the magnet windings. An asymmetric up/down gradient coil on this same surface would be even more efficient but this coil would couple strongly with the magnet. However, an additional set of balancing windings around the lower gradient coil compartment can completely compensate for this net coupling, similarly to how the Z gradient can be decoupled. Even with these additional windings, the stored energy of the decoupled up/down gradient is only 3.9 J, a significant reduction from the 6.9 J of the purely cylindrical gradient.

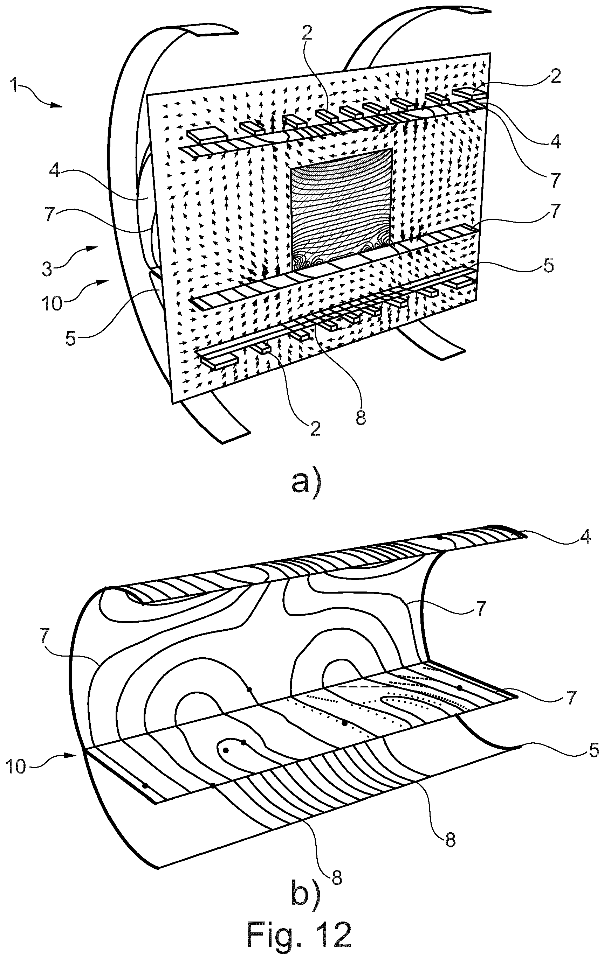

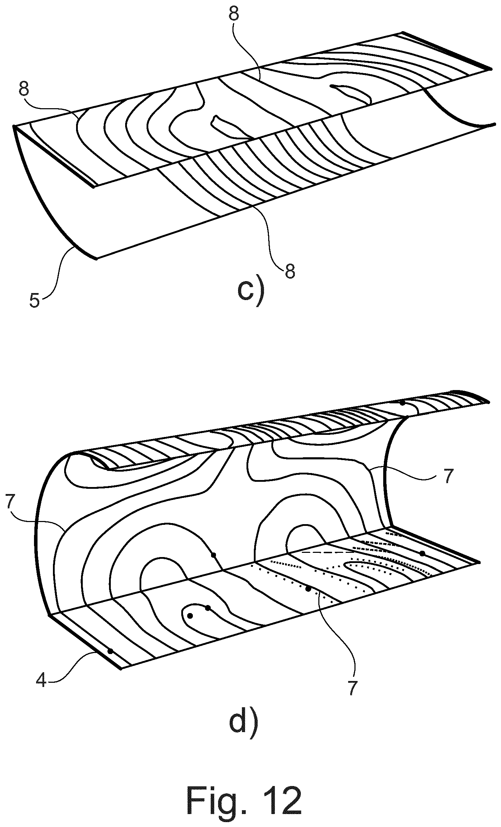

Fig. 12 depicts in Fig. 12 a) a field map of an asymmetric up/down gradient with decoupling coil in lower compartment wherein in Figs. 12 b) to d) parts of the coil are shown separately according to an embodiment of the present invention. Fig. 12 a) shows, as also Fig. 8 a), a magnet coil assembly 1 the assembly comprising a main magnet 2 including superconducting windings 9 to generate a uniform static main magnetic field in an examination zone and an unshielded gradient coil 3 to generate magnetic gradient field waveforms, wherein the unshielded gradient coil 3 has two separate compartments 4, 5, an imaging compartment 4 around an examination zone of the main magnet and at least an auxiliary compartment 5 that is offset adjacent from the imaging compartment 4 in a radial or axial direction of the main magnet 2. The imaging compartment 4 and the auxiliary compartment 5 comprising coil windings 7, 8, wherein the coil windings 7,8 are placed over the surface of the imaging compartment 4 and the auxiliary compartment 5 and are placed each at least in part along the boundary 10 between the compartments 4, 5.

In Figs. 12 b) to c) only parts of the coil for a better overview are shown. In Fig. 12 b) the imaging compartment 4 and auxiliary compartment 5 are shown as sectional drawing. In particular, the coil windings 7, 8 can be recognized on the surface of the compartments 4, 5. In Particular, the coil windings 7, 8 run along the boundary 10 between the compartments 4, 5. In Fig. 12 c) only the auxiliary compartment 5 with its coil windings 8 is shown as sectional drawing. In Fig. 12 d) only the imaging compartment 4 with its coil windings 7 is shown as sectional drawing.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| gradient coil assembly | 1 |
| main magnet | 2 |
| unshielded gradient coil | 3 |
| imaging compartment | 4 |
| auxiliary compartment | 5 |
| gradient coil windings | 6 |
| first compartment coil windings | 7 |
| second compartment coil windings | 8 |
| main magnet windings | 9 |
| boundary between first and second compartment | 10 |

## Claims

1. A magnet coil assembly (1) for a magnetic resonance examination system the assembly comprising
a main magnet (2) including superconducting windings to generate a uniform static main magnetic field in an examination zone and
an unshielded gradient coil (3) to generate magnetic gradient field waveforms, wherein the unshielded gradient coil (3) has two separate compartments (4, 5), an imaging compartment (4) around an examination zone of the main magnet and at least an auxiliary compartment (5) that is offset adjacent from the imaging compartment (4) in a radial or axial direction of the main magnet (2), wherein
the imaging compartment (4) and the auxiliary compartment (5) comprising coil windings (7, 8), wherein the coil windings (7, 8) are placed over the surface of the imaging compartment (4) and the auxiliary compartment (5) and are placed each at least in part along the boundary (10) between the compartments (4, 5).

2. The magnet coil assembly (1) according to claim 1, wherein the coil windings (8) of the auxiliary compartment (5) carry the same current as the coil windings (7) of the imaging compartment (4).

3. The magnet coil assembly (1) according to claim 2, wherein the coil windings (8) of the auxiliary compartment (5) and coil windings (7) of the imaging compartment (4) are connected in series.

4. The magnet coil assembly (1) according to any preceding claim, wherein the imaging compartment (4) surrounds an examination space of the magnetic resonance examination system, wherein the auxiliary compartment (5) is the remainder of the cylindrical coil volume below a patient table of the magnetic resonance examination system.

5. The magnet coil assembly according to any preceding claim, wherein the unshielded gradient coil (3) is a longitudinal z-gradient coil or an asymmetrical up/down-gradient coil.

6. The magnet coil assembly according to any preceding claim, wherein the boundary of the imaging compartment (4) next to the auxiliary compartment (5) is located in the range between 150 and 200 mm below the iso-center of the main magnet (2).

7. A magnetic resonance examination system, the magnetic resonance examination system comprising a magnet coil assembly (1) according to any one of claims 1 to 6.
